# EUROPÄISCHE PATENTSCHRIFT

(11) **EP 3 389 115 B1**
(45) Veröffentlichungstag und Bekanntmachung des Hinweises auf die Patenterteilung: **02.04.2025**
(21) Anmeldenummer: 18158178.6
(22) Anmeldetag: 22.02.2018
(51) Int. Cl.: H01M 10/04, H01M 10/42, H01M 10/48, H01M 50/209, H01M 50/264, H01M 50/289

(54) **MODULAR AUFGEBAUTE BATTERIE MIT VERBESSERTEN SICHERHEITSEIGENSCHAFTEN**
MODULAR BATTERY WITH IMPROVED SAFETY CHARACTERISTICS
BATTERIE MODULAIRE INTÉGRÉE PRÉSENTANT DES CARACTÉRISTIQUES DE SÉCURITÉ AMÉLIORÉES

(30) Priorität: 12.04.2017 DE 102017206358
(43) Veröffentlichungstag der Anmeldung: 17.10.2018
(73) Patentinhaber: VW Kraftwerk GmbH, 38440 Wolfsburg (DE); VARTA Microbattery GmbH, 73479 Ellwangen Jagst (DE)
(72) Erfinder: Knape, Torsten, 73463 Westhausen (DE); Schreiber, Werner, 38527 Meine (DE)
(74) Vertreter: Ostertag & Partner Patentanwälte mbB

(56) Entgegenhaltungen:
- EP-A1- 2 094 523
- DE-A1- 102009 035 482
- DE-A1- 102014 206 813
- JP-A- 2010 205 479
- US-A- 2 812 376
- US-A1- 2006 267 545

## Beschreibung

Die nachfolgend beschriebene Erfindung betrifft eine modular aufgebaute Batterie zur Speicherung elektrischer Energie mit einem Batteriegehäuse, in dem ein Modulverbund aus mindestens zwei Batteriemodulen mit jeweils mindestens einer positiven und mindestens einer negativen Elektrode angeordnet ist, sowie ein Verfahren zum gesicherten Betrieb einer solchen Batterie.

Als Batterien kommen in Elektro- und Hybridfahrzeugen meist modulare Systeme zum Einsatz, die mehrere in Reihe geschaltete Batteriemodule mit jeweils einer positiven und einer negativen Elektrode umfassen. Die Batteriemodule weisen in der Regel jeweils ein Modulgehäuse mit zwei externen Anschlusspolen auf. Einer der Anschlusspole ist mit der mindestens einer positiven Elektrode gekoppelt, der andere mit der mindestens einer negativen Elektrode. Die serielle Verschaltung der Batteriemodule erfolgt in der Regel über die Anschlusspole.

In aller Regel sind die Batteriemodule in einem Modulverbund nebeneinander angeordnet. Meist werden sie mittels eines Spannelements, beispielsweise eines Spanngurts, fest aneinander gedrückt. Der Modulverbund ist wiederum in einem Batteriegehäuse angeordnet. Die mechanischen Kräfte, die beim Laden und Entladen innerhalb des Verbunds entstehen, werden in aller Regel vom Batteriegehäuse aufgefangen. Häufig sind die Batteriemodule hierfür formschlüssig in dem Batteriegehäuse angeordnet.

Es sind modular aufgebaute Batterien bekannt, bei denen die Batteriemodule eines Modulverbunds innerhalb eines Gehäuses durch ein variables Pressmittel aneinander gedrückt werden (DE 102009035482 A1, DE 102014206813 A1 und JP 2010-205497 A, EP2094523 A1, US2006/267545 A1) Bei einer Schädigung eines Batteriemoduls innerhalb des Modulverbunds kann in der Batteriemodul ein interner Kurzschluss entstehen. Gegebenenfalls kommt es zu einer starken Wärmeentwicklung und einer Elektrolytzersetzung sowie einer begleitenden Gasbildung innerhalb des Batteriemoduls. Aufgrund des unmittelbaren Kontakts des beschädigten Batteriemoduls mit den jeweils benachbarten Batteriemodulen kann die in dem defekten Batteriemodul entstehende Wärme über große Kontaktflächen auf die benachbarten Batteriemodule übertragen werden. Das führt zu einem Temperaturanstieg der benachbarten Batteriemodule.

Sehr häufig führt der Temperaturanstieg in den benachbarten Batteriemodulen dazu, dass in diesen chemische Reaktionen in Gang gesetzt werden. In den benachbarten Batteriemodulen kann es in der Folge ebenfalls zu einer Elektrolytzersetzung und einer unkontrollierten Erwärmung kommen. Diese Kettenreaktion (wird oft auch als Propagation bezeichnet) kann zu einer vollständigen Zerstörung des gesamten Modulverbunds und in der Folge auch zur Zerstörung von anderen Komponenten, die sich in der Nähe des Verbunds befinden, führen.

Der vorliegenden Erfindung lag die Aufgabe zugrunde, eine modular aufgebaute Batterie bereitzustellen, die zur Vermeidung der beschriebenen Kettenreaktion bzw. Propagation ein geeignetes Sicherungsmittel aufweist.

Zur Lösung dieser Aufgabe schlägt die Erfindung die im Folgenden beschriebene modular aufgebaute Batterie zur Speicherung elektrischer Energie, insbesondere die bevorzugte Ausführungsform der nachfolgend beschriebenen Batterie mit den in Anspruch 1 genannten Merkmalen, sowie das Verfahren mit den in Anspruch 6 genannten Merkmalen, vor.

Eine modular aufgebaute Batterie gemäß der Erfindung umfasst
- ein Batteriegehäuse, das einen Innenraum umschließt,
- einen Modulverbund aus mindestens zwei Batteriemodulen mit jeweils mindestens einer positiven und mindestens einer negativen Elektrode, und
- ein Pressmittel,
wobei
- der Modulverbund in dem Innenraum des Batteriegehäuse angeordnet ist,
- die mindestens zwei Batteriemodule durch elektrische Verschaltung miteinander verbunden sind,
- die mindestens zwei Batteriemodule in dem Modulverbund nebeneinander angeordnet sind,
- gegebenenfalls zwischen benachbarten Batteriemodulen in dem Modulverbund jeweils ein Trennelement angeordnet ist und
- das Pressmittel auf die Batteriemodule in dem Modulverbund einen Pressdruck ausübt, der benachbarte Batteriemodule des Modulverbunds gegeneinander oder gegen das gegebenenfalls zwischen ihnen angeordnete Trennelement presst.

Bevorzugt sind die benachbarten Batteriemodule in Folge des von dem Pressmittel ausgeübten Drucks jeweils über einen zweidimensionalen Kontaktbereich unmittelbar miteinander oder mit dem gegebenenfalls zwischen ihnen angeordneten Trennelement kraftschlüssig verbunden.

Das Batteriegehäuse ist bevorzugt geschlossen. Auf seiner Außenseite kann es einen oder mehrere Batteriegehäusepole aufweisen, die elektrisch mit den Elektroden der mindestens zwei Batteriemodule verbunden sind und an denen ein elektrischer Verbraucher angeschlossen werden kann. Es kann sowohl aus Metall, beispielsweise aus Aluminium, als auch aus Kunststoff bestehen. Wenn das Batteriegehäuse aus Metall besteht, so kann es eine oder mehrere Poldurchführungen aufweisen, um das Gehäuse potentialfrei zu halten bzw. um einen Kurzschluss zu vermeiden.

Die Batteriemodule können grundsätzlich elektrochemische Zellen jeder Art umfassen. Besonders bevorzugt umfassen die Batteriemodule Batterie- oder Kondensatorzellen oder auch eine Kombination aus Batterie- und Kondensatorzellen. Als Batteriemodule können sowohl Einzelzellen zum Einsatz kommen als auch Zellverbünde, die mehrere Einzelzellen umfassen.

Der einfachste Fall einer Einzelzelle ist eine Zelle umfassend eine positive und eine negative Elektrode, also Zellen mit der Sequenz
- positive Elektrode / Separator / negative Elektrode.

Als Einzelzellen werden weiterhin auch sogenannte Bizellen angesehen, also Zellen mit der Sequenz
- positive Elektrode / Separator / negative Elektrode / Separator / positive Elektrode
   oder
- negative Elektrode / Separator / positive Elektrode / Separator / negative Elektrode.

Als Zellverbund kann beispielsweise ein Stapel aus mehreren Einzelzellen mit einer der genannten Sequenzen zum Einsatz kommen. Enthält eine Zelle oder ein Zellverbund zwei oder mehr Elektroden derselben Polarität, so ist es in der Regel bevorzugt, dass diese über entsprechende Leiter elektrisch miteinander verbunden sind, meist durch Verschweißung.

In einigen bevorzugten Ausführungsformen weist jedes der Batteriemodule ein eigenes Modulgehäuse auf, insbesondere ein Gehäuse aus einer Folie, beispielsweise einer Metallfolie oder einer Metall-Kunststoff-Verbundfolie. In dem Batteriegehäuse sind in diesem Fall also mindestens zwei Batteriemodule in einem jeweils eigenen Modulgehäuse angeordnet.

Weiterhin weist jedes der Batteriemodule in der Regel mindestens einen durch das Modulgehäuse geführten positiven Anschlusspol und mindestens einen durch das Modulgehäuse geführten negativen Anschlusspol auf. Der mindestens eine positive Anschlusspol ist elektrisch mit den positiven Elektroden innerhalb des Modulgehäuses verbunden. Der mindestens eine negative Anschlusspol ist elektrisch mit den negativen Elektroden innerhalb des Modulgehäuses verbunden.

In bevorzugten Ausführungsformen umfassen die mindestens zwei Batteriemodule Einzelzellen oder Zellverbünde auf Basis von Lithium-Ionen, also Zellen, bei denen bei Lade- und Entladevorgängen Lithium-Ionen von der positiven zur negativen Elektrode und umgekehrt wandern. Die Zellen können insbesondere in Form von Wickeln oder gestapelt vorliegen.

In einigen besonders bevorzugten Ausführungsformen umfassen die mindestens zwei Batteriemodule jeweils mindestens eine Zelle auf Basis von C//NMC (Kohlenstoff / Nickel-Mangan-Kobalt) und/oder auf Basis von C//LFP (Kohlenstoff / Li-Eisenphosphat).

Bevorzugt umfassen die Batteriemodule einen für die von ihnen umfassten Zellen geeigneten Elektrolyten. Im Falle von Einzelzellen oder Zellverbünden auf Basis von Lithium-Ionen handelt es sich hierbei bevorzugt um einen organischen Elektrolyten, insbesondere auf Basis organischer Carbonate.

Die mindestens zwei Batteriemodule sind bevorzugt durch serielle elektrische Verschaltung miteinander verbunden. Grundsätzlich kann die Batterie aber auch parallel verschaltete Batteriemodule umfassen.

Bevorzugt sind benachbarte Batteriemodule in dem Modulverbund über mindestens ein Kontaktmittel elektrisch und mechanisch miteinander verbunden. Das mindestens eine Kontaktmittel verbindet dabei bevorzugt die Anschlusspole der benachbarten Batteriemodule. Mit diesen ist es jeweils elektrisch und mechanisch verbunden. Die mechanische Verbindung kann beispielsweise eine Schweißverbindung, Nietverbindung, Schraubverbindung, Lötverbindung oder eine Klemmverbindung sein.

Bevorzugte Kontaktmittel weisen besonders bevorzugt mindestens eine der folgenden Eigenschaften auf:
- Sie bestehen aus einem mechanisch flexiblen elektrisch leitfähigen Material, beispielsweise aus einem oder mehreren biegbaren Metalldrähten oder aus einer biegbaren Metallfolie oder einem biegbaren Metallblech.
- Sie weisen zwei Kontaktbereiche auf, die mit Anschlusspolen zweier benachbarter Batteriemodule verbunden sind.
- Zwischen den Kontaktbereichen weisen die Kontaktmittel mindestens einen Biege-, Falt- oder Torsionsbereich auf, in dem sie gebogen, gefaltet oder tordiert sind.
- Die Kontaktmittel weisen insgesamt eine größere Länge auf, als zum Verbinden der Anschlusspole erforderlich wäre.

Besonders bevorzugt umfasst die Batterie 2 bis 50 der durch elektrische Verschaltung miteinander verbundenen Batteriemodule, besonders bevorzugt zwischen 10 und 30 der Batteriemodule.

Die Batteriemodule weisen bevorzugt alle die gleiche Größe und Dimensionen auf. Besonders bevorzugt sind die Batteriemodule prismatisch, insbesondere quaderförmig, ausgebildet. In diesem Fall umfasst das Modulgehäuse der Batteriemodule einen rechteckigen Gehäuseboden, vier im rechten Winkel dazu angeordnete Seitenwände sowie ein Gehäuseoberteil, das im Wesentlichen die gleiche Form und Größe wie der Gehäuseboden aufweist. Der Gehäuseboden, die Seitenwände und das Gehäuseoberteil sind bevorzugt kaum profiliert. Besonders bevorzugt sind ihre äußeren Oberflächen eben oder zumindest näherungsweise eben.

Bei dem zwischen den Batteriemodulen gegebenenfalls angeordneten Trennelement kann es sich um ein Wärmeleitelement handeln, das dazu dient, Wärme aus dem Modulverbund abzuführen. Dazu kann das Trennelement beispielsweise als wärmeleitfähige Metallplatte ausgebildet sein. Bei dem Trennelement kann es sich aber auch um ein thermisches Isolierelement handeln, das verhindern soll, dass Wärme zwischen benachbarten Batteriemodulen in dem Modulverbund ausgetauscht wird.

Das Trennelement kann beispielsweise plattenförmig ausgebildet sein.

Als Pressmittel eignen sich grundsätzlich alle Einrichtungen oder Anordnungen, durch die auf die Batteriemodule in dem Modulverbund der gewünschte Pressdruck ausgeübt werden kann. In bevorzugten Ausführungsformen ist das Pressmittel durch mindestens eines der folgenden zusätzlichen Merkmale gekennzeichnet:
- Das Pressmittel ist oder umfasst mindestens ein Spannband, insbesondere mindestens ein elastisch gedehntes Spannband, das den Modulverbund umschließt.
- Das Pressmittel ist oder umfasst mindestens einen Spannrahmen, der den Modulverbund umschließt.
- Das Pressmittel umfasst mindestens eine Spannfeder.
- Das Pressmittel umfasst mindestens einen Zuganker, der am und/oder in dem Modulverbund verlegt ist.

Besonders bevorzugt umfasst oder ist das Pressmittel somit eine Einrichtung, die unter Zugspannung steht. So kann das Pressmittel beispielsweise Andruckplatten umfassen, zwischen denen der Modulverbund angeordnet ist und an denen das mindestens eine Spannband, die mindestens eine Spannfeder oder der mindestens eine Zuganker befestigt sind. Die Andruckplatten werden durch das mindestens eine Spannband, die mindestens eine Spannfeder oder den mindestens eine Zuganker zusammengezogen und üben auf diese Weise den gewünschten Pressdruck auf die Batteriemodule in dem Modulverbund aus.

Weiterhin besteht das Pressmittel somit bevorzugt aus einem elastischen Material oder es umfasst bevorzugt eine oder mehrere Komponenten aus einem elastischen Material.

In besonders bevorzugten Ausführungsformen ist das Pressmittel
- ein Spannband aus Kunststoff oder aus einem Verbundwerkstoff aus Kunststoff und einem Fasermaterial, das den Modulverbund umschließt, insbesondere ein elastisch gedehntes Spannband aus Kunststoff oder aus einem Verbundwerkstoff aus Kunststoff und einem Fasermaterial, das den Modulverbund umschließt.

Das Spannband kann aber durchaus auch aus anderen Materialien bestehen, beispielsweise aus Metall.

In einigen bevorzugten Ausführungsformen ist das Batteriegehäuse selbst das Pressmittel oder Teil des Pressmittels. Es ist möglich, den Modulverbund in dem Batteriegehäuse derart anzuordnen, dass der Pressdruck von gegenüberliegenden Wänden des Batteriegehäuses ausgeübt wird. Das Batteriegehäuse dient also selbst als Spannrahmen.

Es ist weiterhin möglich, dass der Modulverbund an einer Wand des Batteriegehäuses anliegt und beispielsweise mittels eines Keils, mittels einer Feder oder mittels eines komprimierten Gases oder einer unter Druck stehenden Flüssigkeit gegen diese Wand gepresst wird. In diesen Fällen sind sowohl die Wand, gegen die der Modulverbund gepresst wird, als auch das hierfür benötigte Hilfsmittel, beispielsweise der erwähnte Keil, die erwähnte Feder oder das komprimierte Gas oder die unter Druck stehende Flüssigkeit, Bestandteile des Pressmittels.

Innerhalb des Modulverbunds stehen die einzelnen Batteriemodule untereinander oder mit zwischen ihnen angeordneten Trennelementen bevorzugt über die erwähnten Seitenwände in Kontakt. Bevorzugt weist jedes der Batteriemodule zwei gegenüberliegende, parallel zueinander angeordnete Außenseiten auf, über die sie in Kontakt mit benachbarten Batteriemodulen stehe können. Da die Außenseiten in der Regel flach sind, ist der Kontaktbereich sehr groß. In der Regel entspricht er der Fläche der Außenseiten bzw. der Seitenwände.

Besonders zeichnet sich die erfindungsgemäße Batterie dadurch aus, dass sie
- mindestens ein Sicherungsmittel aufweist, das bei einem Defekt mindestens eines der Batteriemodule eine Reduzierung des auf die Batteriemodule ausgeübten Pressdrucks herbeiführt. Das Sicherungsmittel ist oder umfasst hierbei ein Mittel zur Zerstörung des Pressmittels, das das Pressmittel im Fall des Defekts zerstört.

Bevorzugt führt das Sicherungsmittel nicht nur eine Reduzierung sondern einen vollständigen Wegfall des Pressdrucks herbei.

Durch die Reduzierung oder den Wegfall des Pressdrucks kann in dem Modulverbund Entspannung eintreten. Benachbarte Zellen berühren sich nicht mehr zwingend über den kompletten zweidimensionalen Kontaktbereich. Zumindest werden sie nicht mehr durch eine externe Kraft aneinander gepresst. Hieraus resultiert ein deutlich verringerter Wärmeübertrag zwischen benachbarten Batteriemodulen. Der eingangs beschriebenen Propagation wird entgegengewirkt.

Besonders effizient ist die erfindungsgemäße Lösung im Falle von Batteriemodulen mit einem eigenen Modulgehäuse aus einer Folie. Bei einer Gasentwicklung innerhalb des Modulgehäuses kann sich dieses aufblähen. Die Außenseiten des Foliengehäuses sind dann nicht mehr eben, stattdessen weisen sie eine konvexe Geometrie auf. Dieser Formänderung wirkt der auf die Batteriemodule ausgeübte Pressdruck entgegen. Entfällt dieser, so können benachbarte Batteriemodule durch das sich aufblähende Gehäuse auseinandergeschoben werden. Dadurch verringert sich zwingend der Kontaktbereich zwischen dem Batteriemodul mit dem aufgeblähten Gehäuse und den benachbarten, noch intakten Batteriemodulen. Dadurch sinkt auch der Wärmeübergang von dem defekten Batteriemodul zu den intakten Batteriemodulen.

Das Auseinanderschieben der Batteriemodule funktioniert in den Fällen, in denen die erfindungsgemäße Batterie Kontaktmittel umfasst, die den mindestens einen Biege-, Falt- oder Torsionsbereich aufweisen, besonders gut. Ein Biege,- Falt oder Torsionsbereich gewährleistet, dass die Batteriemodule von den Kontaktmitteln nicht in einer Art und Weise zusammengehalten werden, die ein Auseinanderschieben unmöglich macht. Stattdessen können sich die gebogenen, gefalteten oder tordierten Kontaktmittel im Falle eines Auseinanderschiebens strecken, so dass sich die mittels der Kontaktmittel verbundenen Anschlusspole voneinander entfernen können. Die Kontaktmittel setzen dem Vorgang des Auseinanderschiebens keinen Widerstand entgegen.

In besonders bevorzugten Ausführungsformen zeichnet sich die erfindungsgemäße Batterie durch eine Sensorik aus, über die Parameter erfasst werden können, die auf einen Defekt zurückzuführen sind. Zu diesen Parametern zählen insbesondere Kräfte, die auf das Pressmittel ausgeübt werden, Temperaturen in dem Batteriegehäuse, insbesondere Temperaturen einzelner Batteriemodule, Änderungen der von der Batterie oder einzelnen Batteriemodulen abgegebenen elektrischen Spannung und Änderungen des von der Batterie oder einzelnen Batteriemodulen abgegebenen elektrischen Stroms.

Erfindungsgemäß zeichnet sich die Batterie entsprechend durch mindestens eines der folgenden zusätzlichen Merkmale aus:
- Sie umfasst eine Kraftmesseinrichtung, mit der eine Kraft, die dem von dem Pressmittel ausgeübten Pressdruck entgegengerichtet ist, detektieren werden kann.
- Die Kraftmesseinrichtung ist Bestandteil des Modulverbunds oder des Pressmittels.
- Sie umfasst eine Temperaturmesseinrichtung, insbesondere umfassend mindestens einen Temperatursensor, die eine Temperatur in dem Batteriegehäuse und/oder eine Temperatur einzelner Batteriemodule des Modulverbunds detektieren kann.
- Sie umfasst eine Spannungsmesseinrichtung, die eine Änderung einer von dem Modulverbund abgegebenen elektrischen Spannung in Folge eines Defekts mindestens eines der Batteriemodule des Modulverbunds detektieren kann.
- Sie umfasst eine Strommesseinrichtung, die eine Änderung des von dem Modulverband abgegebenen Stroms in Folge eines Defekts mindestens eines der Batteriemodule des Modulverbunds detektieren kann.

Insbesondere die Temperaturmesseinrichtung kann auch Bestandteil eines der Batteriemodule des Modulverbunds sein. Bevorzugt ist jedem der Batteriemodule des Modulverbunds eine eigene Temperaturmesseinrichtung zugeordnet.

Die erfindungsgemäße Batterie umfasst eine Datenverarbeitungseinrichtung, die mit der Temperaturmesseinrichtung und/oder mit der Kraftmesseinrichtung und/oder mit der Spannungsmesseinrichtung und/oder der Strommesseinrichtung gekoppelt ist. Die Einrichtung oder die Einrichtungen ist oder sind bevorzugt derart mit der Datenverarbeitungseinrichtung gekoppelt, dass sie Messergebnisse an die Datenverarbeitungseinrichtung übermitteln können, insbesondere auch erfasste Parameter, die auf den erwähnten Defekt zurückzuführen sind.

Weiterhin ist das Mittel zur Zerstörung mit der Datenverarbeitungseinrichtung gekoppelt und initiiert die Zerstörung des Pressmittels auf ein Signal der Datenverarbeitungseinrichtung.

Die Datenverarbeitungseinrichtung ist besonders bevorzugt dazu konfiguriert, Temperaturänderungen in dem Batteriegehäuse oder in einem einzelnen Batteriemodul pro Zeiteinheit erfassen zu können. Ein Indikator für einen Defekt eines Batteriemoduls ist beispielsweise ein Überschreiten eines maximalen Temperaturschwellenwerts, beispielsweise einer Temperatur von 80 °C. Darüber hinaus kann aber auch ein sehr starker Temperaturanstieg innerhalb einer sehr kurzen Zeitspanne ein zuverlässiger Indikator für einen Defekt sein, beispielsweise ein Anstieg der Temperatur eines Batteriemoduls um 20 °C innerhalb von maximal 5 Sekunden.

Die Kraftmesseinrichtung und/oder die Temperaturmesseinrichtung und/oder die Spannungsmesseinrichtung und/oder die Strommesseinrichtung können mit dem mindestens einen Sicherungsmittel verbunden sein, so dass eine von der Kraftmesseinrichtung detektierte Kraft und/oder eine von der Temperaturmesseinrichtung detektierte Temperaturänderung und/oder eine von der Spannungsmesseinrichtung detektierte Spannungsänderung und/oder eine von der Strommesseinrichtung detektierte Änderung des abgegebenen Stroms das Sicherungsmittel auslösen können. So kann es beispielsweise vorgesehen sein, dass der erwähnte Temperaturschwellenwert definiert wird, bei dem das Sicherungsmittel auslösen soll. Weiterhin kann definiert werden, dass z.B. ein Temperaturanstieg innerhalb eines Batteriemoduls um 20 °C in einem Zeitraum < 5 Sekunden das Sicherungsmittel auslösen soll.

Besonders bevorzugt sind die Temperaturmesseinrichtung und/oder die Spannungsmesseinrichtung und/oder die Strommesseinrichtung über die Datenverarbeitungseinrichtung mit dem mindestens einen Sicherungsmittel verbunden. Die Temperaturmesseinrichtung und/oder die Spannungsmesseinrichtung und/oder die Strommesseinrichtung können Daten, insbesondere die erwähnten Änderungen von Spannung, Temperatur und Strom, erfassen und an die Datenverarbeitungseinrichtung weitergeben. Diese kann dann beim Eintreten eines oder mehrerer definierter Parameter, beispielsweise beim Überschreiten eines Temperaturschwellenwerts, die Sicherheitseinrichtung auslösen. Hierzu kann ein Signal von der Datenverarbeitungseinrichtung an das Sicherungsmittel übermittelt werden.

Erfindungsgemäß ist die Datenverarbeitungseinrichtung dazu ausgebildet, einen Messwert von einer der Einrichtungen mit einem gespeicherten Schwellenwert, dessen Überschreitung einen Defekt in mindestens einem der Batteriemodule anzeigt, abzugleichen und ausschließlich im Fall einer Überschreitung dieses Schwellenwerts das Sicherungsmittel auszulösen.

Die Datenverarbeitungseinrichtung ist in bevorzugten Ausführungsformen Bestandteil der erfindungsgemäßen Batterie. Sie ist dann bevorzugt in dem Innenraum des Batteriegehäuses angeordnet.

In einigen anderen Ausführungsformen ist die Datenverarbeitungseinrichtung der Batterie lediglich zugeordnet. Die Batterie und die Datenverarbeitungseinrichtung sind dann Teile eines Energiespeichersystems, das gegebenenfalls auch mehr als eine der erfindungsgemäßen Batterien umfassen kann. Die Datenverarbeitungseinrichtung kann dann beispielsweise auch die Funktion eines der Batterie zugeordneten Batteriemanagementsystems übernehmen oder Teil eines solchen Systems sein.

Es wurde bereits beschrieben, dass sich Batteriemodule mit einem eigenen Modulgehäuse aus einer Folie bei einem Defekt aufblähen können. Das Aufblähen führt in aller Regel zu einer dem von dem Pressmittel ausgeübten Pressdruck entgegen gerichteten Kraft. Diese kann beispielsweise mittels der Kraftmesseinrichtung erfasst werden.

In weiteren bevorzugten Ausführungsformen zeichnet sich die erfindungsgemäße Batterie durch mindestens eines der folgenden zusätzlichen Merkmale aus:
- Das Batteriegehäuse ist flüssigkeitsdicht und gasdicht verschlossen.
- Das Batteriegehäuse umschließt einen Innenraum, in dem der Modulverbund angeordnet ist, wobei der Modulverbund den Innenraum nicht vollständig ausfüllt, so dass ein Totvolumen verbleibt.
- Das Totvolumen nimmt zwischen 1 % und 30 %, bevorzugt zwischen 1 % und 15 %, des Innenraums ein.

Das Vorhandensein des Totvolumens kann zweckmäßig sein, um zu gewährleisten, dass der Modulverband bei einem Auslösen des mindestens einen Sicherungsmittels entspannen kann. In dem Totvolumen können aber auch das Sicherungsmittel oder Bestandteile des Sicherungsmittels angeordnet sein.

In weiteren bevorzugten Ausführungsformen zeichnet sich die erfindungsgemäße Batterie durch mindestens eines der folgenden zusätzlichen Merkmale aus:
- Das Sicherungsmittel ist dazu ausgebildet, das Presselement oder ein Bestandteil des Presselements zur Reduzierung des Pressdrucks zu zerstören.
- Das Sicherungsmittel ist dazu ausgebildet, einen Druck herbeizuführen, der dem Pressdruck, der die Batteriemodule in dem Modulverbund gegeneinander presst, entgegengerichtet ist.

In Abhängigkeit der Ausgestaltung des Pressmittels gibt es jeweils zahlreiche Möglichkeiten, um eine Zerstörung des Pressmittels zu bewirken.

Es ist möglich, innerhalb des Batteriegehäuses, insbesondere unter Nutzung des erwähnten Totvolumens, als Bestandteil des Sicherungsmittels ein Mittel zur Zerstörung des Pressmittels anzuordnen, das das Pressmittel im Falle eines Defekts mindestens eines der Batteriemodule zerstört. Die Batterie kann zu diesem Zweck als weiteren Bestandteil des Sicherungsmittels einen Aktuator, der gegebenenfalls ebenfalls in dem Totvolumen angeordnet sein kann, aufweisen. Dieser kann mit der Datenverarbeitungseinrichtung gekoppelt sein und auf ein Signal derselben die Zerstörung des Pressmittels initiieren. Der Datenverarbeitungseinrichtung kann somit auch eine steuernde Funktion zukommen.

Handelt es sich bei dem Pressmittel um das erwähnte Spannband, so kann es sich bei dem Mittel zur Zerstörung des Pressmittels beispielsweise um ein Schneidwerkzeug handeln. Auf ein Signal der Datenverarbeitungseinrichtung hin kann eine scharfe Kante des Schneidwerkzeugs gegen das Spannband gepresst werden um dieses zu durchtrennen.

In einer weiteren Ausführungsform kann eine Zerstörung des Spannbandes unter Verwendung eines Materials mit einer überproportionalen Ausdehnung bei einem Temperaturanstieg innerhalb des Batteriegehäuses herbeigeführt werden. Ein solches Material kann sich in Folge einer Erwärmung innerhalb des Batteriegehäuses stark ausdehnen und eine mechanische Kraft auf ein Mittel zur Zerstörung des Pressmittels, beispielsweise das erwähnte Schneidwerkzeug, ausüben. Ein von der Datenverarbeitungseinrichtung gesteuerter Aktuator ist hierbei nicht erforderlich.

In Fällen, in denen - wie oben beschrieben - der Modulverbund an einer Wand des Batteriegehäuses anliegt und beispielsweise mittels des erwähnten Hilfsmittels gegen diese Wand gepresst wird, kann das Hilfsmittel mit Hilfe des Aktuators zerstört werden. So kann es beispielsweise vorgesehen sein, dass ein Behälter, in dem die oben erwähnte unter Druck stehende Flüssigkeit angeordnet ist, mit Hilfe des Aktuators zerstört wird.

In besonders bevorzugten Ausführungsformen umfasst die Batterie als Sicherungsmittel ein elastisch gedehntes Spannband, das ganz oder teilweise aus einem Material besteht, das bei einer Erwärmung über einen Temperaturschwellenwert hinaus seine elastischen Eigenschaften verliert und/oder reißt, so dass die gewünschte Reduzierung des Pressdrucks resultiert.

Das Sicherungsmittel kann somit auch in einer besonderen Ausgestaltung des Pressmittels oder einem Bestandteil des Pressmittels, also beispielsweise des Spannbands, bestehen.

Insbesondere wenn es sich bei dem Pressmittel um ein Spannband aus Metall oder Kunststoff oder aus einem kunststoffbasierten Material, beispielsweise einem Verbundwerkstoff aus Kunststoff und einem Fasermaterial, das den Modulverbund umschließt, handelt, so kann es sich bei dem Sicherungsmittel auch um ein Mittel zur thermischen Zerstörung des Spannbands handeln, beispielsweise um ein Mittel zum Zerstören des Spannbands durch Aufschmelzen des Materials, aus dem das Spannband besteht.

In einer besonders bevorzugten Ausführungsform kann das Sicherungsmittel ein Heizelement zur thermischen Zerstörung des Pressmittels umfassen, welches zur Erzeugung von Wärme, die zu einem Aufschmelzen oder einer Zersetzung des Materials, aus dem das Pressmittel besteht, führt, ausgelegt ist. Hierzu kann das Heizelement beispielsweise einen Heizdraht oder ein heizbares Messer aufweisen.

Bevorzugt steht das Heizelement in unmittelbarem Kontakt mit dem Pressmittel, insbesondere mit dem Spannband, so dass es die Wärme unmittelbar an das Pressmittel abgeben beziehungsweise an das Pressmittel übertragen kann.

In besonders bevorzugten Ausführungsformen wird dieses Heizelement mit elektrischer Energie aus der modular aufgebauten Batterie gespeist. Zu diesem Zweck kann es elektrisch mit Anschlusspolen eines oder mehrerer Batteriemodule des Modulverbunds gekoppelt sein. Grundsätzlich ist es aber auch möglich, das Heizelement mit einer externen Energiequelle zu verbinden. Es ist es jedoch bevorzugt, dass das Heizelement mit elektrischer Energie aus der modular aufgebauten Batterie gespeist wird, da in diesem Fall lediglich eine elektrische Kontaktierung innerhalb des Gehäuses erforderlich ist.

Das Heizelement kann durch die Datenverarbeitungseinrichtung gesteuert werden. Bevorzugt ist dem Heizelement eine Schaltvorrichtung zugeordnet, über die es aktiviert werden kann. Gegebenenfalls ist die Schaltvorrichtung mit der Datenverarbeitungseinrichtung gekoppelt und kann von dieser geschaltet werden. Die Schaltvorrichtung kann ein separates Bauteil sein, insbesondere innerhalb des Batteriegehäuses, oder sie kann Bestandteil des Heizelements sein.

Die Reduzierung des auf die Batteriemodule ausgeübten Pressdrucks erfolgt also bevorzugt, indem das Pressmittel zerstört wird. Der auf die Batteriemodule ausgeübte Pressdruck wird in dieser Ausführungsform nicht nur verringert, sondern auf Null reduziert.

Insbesondere in Fällen, in denen das Batteriegehäuse selbst als Spannrahmen dient, ist das Sicherungsmittel bevorzugt dazu ausgebildet, das Gehäuse zu zerstören oder zerstörungsfrei zu öffnen. So kann das Batteriegehäuse als Sicherungsmittel oder als Bestandteil eines Sicherungsmittels beispielsweise eine oder mehrere Sprengschnüre umfassen, mit denen das Gehäuse zur Reduzierung des Pressdrucks an definierten Stellen zerstört wird. Beispielsweise können eine oder mehrere Sprengschnüre im Kantenbereich an eine der Wände des Batteriegehäuses positioniert werden, so dass die Wand bei einem Defekt eines Batteriemoduls durch Auslösung einer Sprengung aus dem Batteriegehäuse herausgetrennt werden kann.

Das Gehäuse kann zusätzlich mit Sollbruchstellen versehen sein, beispielsweise an den erwähnten Kantenbereichen.

Von der vorliegenden Erfindung umfasst ist auch ein Verfahren zum gesicherten Betrieb einer Batterie mit den obigen Merkmalen. Das Verfahren zeichnet sich dadurch aus, dass die Batterie mit dem beschriebenen mindestens einen Sicherungsmittel ausgestattet wird, das bei einem Defekt mindestens eines der Batteriemodule eine Reduzierung des auf die Batteriemodule ausgeübten Pressdrucks herbeiführt.

Weitere Merkmale, Einzelheiten und Vorzüge der Erfindung ergeben sich aus den Ansprüchen und der Zusammenfassung, deren beider Wortlaut durch Bezugnahme zum Inhalt der Beschreibung gemacht wird, der folgenden Beschreibung bevorzugter Ausführungsformen der Erfindung sowie anhand der Zeichnungen. Hierbei zeigen:
Figur 1 schematisch einen möglichen Aufbau einer erfindungsgemäßen Batterie mit einem zweiteiligen Batteriegehäuse und einer bevorzugten Ausführungsform eines Modulverbunds;
Figur 2 schematisch das Verhalten des Modulverbunds der in Figur 1 dargestellten erfindungsgemäßen Batterie im Falle des Defekts eines Batteriemoduls;
Figur 3 schematisch den Aufbau eines einzelnen Batteriemoduls, das Bestandteil des in Figur 2 dargestellten Modulverbunds ist;
Figur 4 und Figur 5 schematisch die Anordnung des in Fig. 1 dargestellten Modulverbunds in einem Teil des in Fig. 1 dargestellten Batteriegehäuses (Darstellung eines Längsschnitts);
Figur 6 schematisch den Aufbau eines weiteren einzelnen Batteriemoduls, das Bestandteil des Modulverbunds einer erfindungsgemäßen Batterie sein kann;
Figur 7 schematisch die Kopplung einer Datenverarbeitungseinrichtung mit einer Sensorik und einem Mittel zur Zerstörung des Pressmittels.

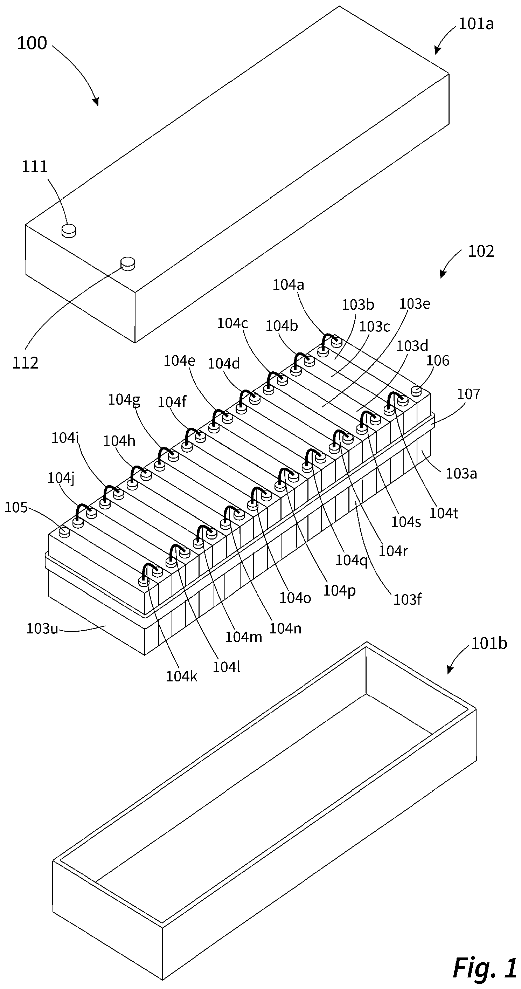

Die in Figur 1 dargestellte Batterie 100 besteht aus einem zweiteiligen Batteriegehäuse 101a, 101b und einem in dem Batteriegehäuse angeordneten Modulverbund 102 aus einer Vielzahl von identisch ausgebildeten Batteriemodulen 103a bis 103u. Der besseren Übersicht wegen sind die zwei Bestandteile 101a und 101b des Batteriegehäuses und der Modulverbund 102 der Batterie 100 einzeln dargestellt.

Die Batteriemodule 103a bis 103u sind mittels des als Pressmittel dienenden Spannbands 107 zu dem Modulverbund 102 zusammengefasst. Das Spannband 107 steht unter Spannung. Es übt auf die Batteriemodule 103a bis 103u einen Pressdruck aus, der die Batteriemodule 103a bis 103u gegeneinander presst. Bei dem Spannband 107 handelt es sich um ein elastisch gedehntes Spannband, das bei einer Erwärmung über einen Temperaturschwellenwert von 80 °C hinaus seine elastischen Eigenschaften verliert, so dass der von dem Spannband ausgeübte Pressdruck sinkt. Wird der Temperaturschwellenwert überschritten und wirkt auf das Band zusätzlich eine dem von dem Spannband ausgeübten Pressdruck entgegengesetzte Kraft, so kann das Spannband sogar reißen.

Das Batteriegehäuseteil 101a umfasst die externen Batteriegehäusepole 111 und 112. Diese sind im Betriebszustand über die Anschlusspole 105 und 106 elektrisch mit den Elektroden der Batteriemodule 103a bis 103u verbunden. Die einzelnen Batteriemodule 103a bis 103u sind über die Kontaktmittel 104a bis 104t seriell miteinander verschaltet. Bei den Kontaktmitteln handelt es sich um Metalldrähte, deren Enden jeweils an die zu verbindenden Anschlusspole fixiert sind. Zwischen diesen endständigen Kontaktbereichen weisen sie jeweils einen Biegebereich auf, in dem sie gebogen sind. Sie weisen also insgesamt eine größere Länge auf, als zum Verbinden der Anschlusspole erforderlich wäre.

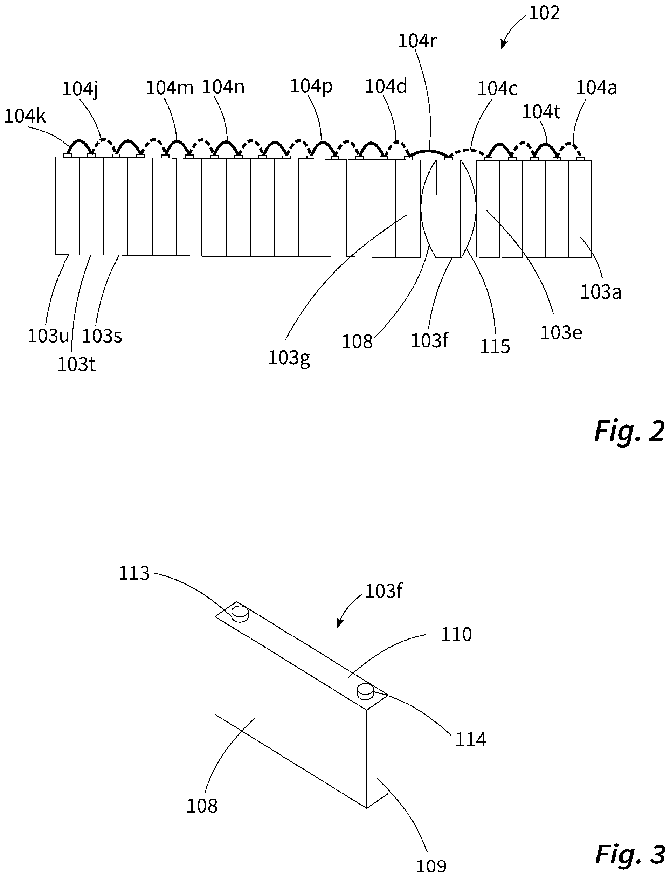

Der Aufbau der Batteriemodule 103a bis 103u lässt sich anhand von Figur 3 veranschaulichen, in der exemplarisch das Batteriemodul 103f dargestellt ist. Das Batteriemodul 103f ist quaderförmig ausgebildet und weist ein Modulgehäuse aus einer Folie auf. Das Modulgehäuse des Batteriemoduls 103f umfasst einen rechteckigen Gehäuseboden (nicht sichtbar), vier im rechten Winkel dazu angeordnete Seitenwände (sichtbar sind die Seitenwände 108 und 109) sowie ein Gehäuseoberteil 110 auf. Die hier nicht sichtbaren Seitenwände korrespondieren in Form und Größe mit den Seitenwänden 108 und 109 (die zur Seitenwand 108 parallele Seitenwand 115 ist in deformierter Form in Figur 2 dargestellt). Analoges gilt für den Gehäuseboden, der, abgesehen von zwei Durchführungen für die externen Anschlusspole 113 und 114, die gleiche Form und Größe wie das Gehäuseoberteil 110 aufweist. Der Außenseiten des Gehäusebodens, der Seitenwände 108 und 109 und des Gehäuseoberteils 110 sind eben oder zumindest näherungsweise eben.

Innerhalb des in Figur 1 dargestellten Modulverbunds 102 stehen die einzelnen Batteriemodule 103a bis 103u über ihre Seitenwände miteinander in Kontakt. Die Seitenwände liegen flächig aneinander. Hieraus resultierte ein zweidimensionaler Kontaktbereich zwischen benachbarten Batteriemodulen innerhalb des Stapels, beispielsweise zwischen den Batteriemodulen 103e und 103f, dessen Größe der Fläche der Seitenwände entspricht, über die die Batteriemodule miteinander in Kontakt stehen.

Das in Figur 3 dargestellte Batteriemodul 103f ist in Figur 2 im Defektfall dargestellt. In Folge eines internen Kurzschlusses kam es zu einer Temperaturerhöhung und zu einem Aufblähen der Seitenwände 108 und 115 des Batteriemoduls 103f. Die hieraus resultierende Krafteinwirkung auf das Spannband 107 oder ein in Folge der Temperaturerhöhung ausgelöstes Mittel zur Zerstörung des Spannbands 107 führte zu einem Reißen des Spannbands 107. In Folge des Wegfalls des Spannbands 107 sind die Batteriemodule 103a bis 103u nur noch über die Kontaktmittel 104a bis 104t miteinander verbunden. Hierbei sind die zum Betrachter weisenden Kontaktmittel 104k bis 104t mittels durchgezogener Linien dargestellt, die weiter hinten liegenden Kontaktmittel 104a bis 104j sind gestrichelt dargestellt.

Die aus den Batteriemodulen 103a - 103e und aus den Batteriemodulen 103g - 103u bestehenden Segmente des Modulverbunds 102 können in Folge des Wegfalls des Spannbands durch das sich aufblähende Gehäuse des Batteriemoduls 103f widerstandslos auseinander geschoben werden. Die Kontaktmittel 104c und 104r sind ausreichend lang um dies zu gestatten. Auch das aus den Teilen 101a und 101b bestehende Batteriegehäuse weist hierfür eine ausreichende Länge auf. Dadurch verringert sich der Kontaktbereich zwischen dem defekten Batteriemodul 103f und den benachbarten, noch intakten Batteriemodulen 103e und 103g. Weiterhin sinkt dadurch auch der Wärmeübergang von dem defekten Batteriemodul 103f zu den intakten Batteriemodulen 103e und 103g.

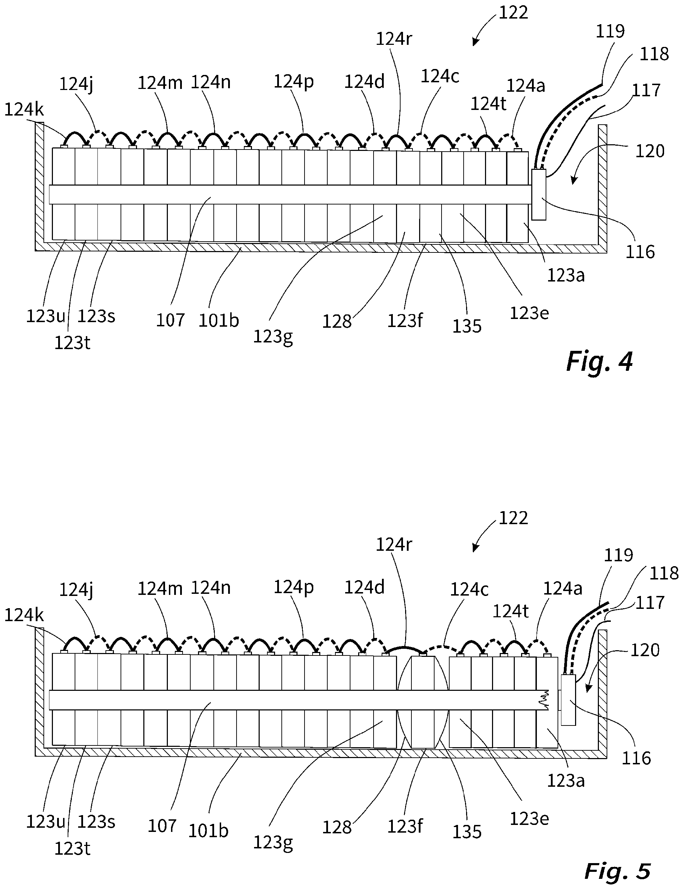

Anhand der Figuren 4 und 5 lässt sich die Funktionsweise des Sicherungsmittels veranschaulichen. Dargestellt ist jeweils ein Längsschnitt durch das in Fig. 1 dargestellte Batteriegehäuseteil 101b, in dem der Modulverbund 102 angeordnet ist. Der Übersichtlichkeit halber ist das Batteriegehäuse offen, also ohne das Batteriegehäuseteil 101a, dargestellt.

Klar zu erkennen ist, dass der Modulverbund 102 das Gehäuse nicht vollständig ausfüllt. Es verbleibt ein Totvolumen 120, in das der Modulverbund bei Bedarf expandieren kann und in dem weitere Komponenten der Batterie angeordnet werden können. Vorliegend ist in dem Totvolumen 120 das Heizelement 116 angeordnet, das unmittelbar mit dem Spannband 107 in Kontakt steht und das als Mittel zur Zerstörung des Pressmittels, also des Spannbands 107, dient.

Das Heizelement 116 bezieht die für seinen Betrieb erforderliche Energie bevorzugt aus dem Modulverbund 102. Zu diesem Zweck kann es über die elektrischen Leitungen 118 und 119 beispielsweise mit den Polen 105 und 106 gekoppelt sein. Die elektrischen Leitungen sind aus Gründen der Übersichtlichkeit nur im Ansatz dargestellt. Über die Leitung 117 kann das Heizelement 116 mit einer Datenverarbeitungseinrichtung gekoppelt sein, von der es im Defektfall aktiviert wird.

Während Figur 4 die Situation im Normalbetrieb, also ohne Defekt, illustriert, ist in Fig. 5 der Defektfall dargestellt. Hier wurde das Spannband 107 mittels des Heizelements 116 durch Erwärmung zerstört. In der Folge konnten die Seitenwände 128 und 135 des defekten Batteriemoduls 123f ohne großen Widerstand aufblähen und das Modul in das Totvolumen 120 expandieren.

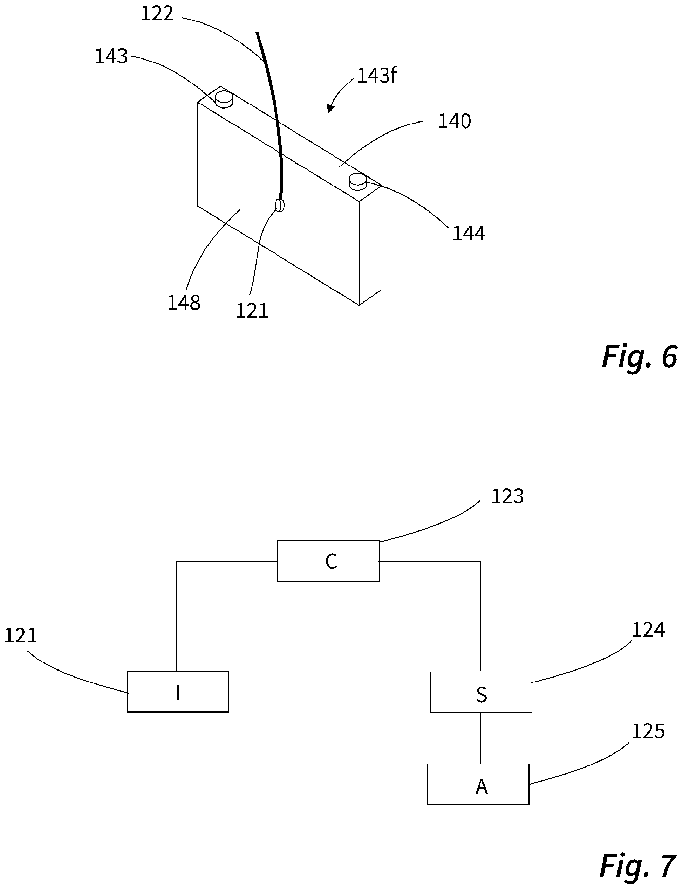

Das in Figur 6 dargestellte Batteriemodul unterscheidet sich von dem in Fig. 3 dargestellten lediglich darin, dass es als Temperaturmesseinrichtung, die seine Temperatur detektieren kann, den Temperatursensor 121 aufweist. Dieser kann die gemessene Temperatur über das Kabel 122 an eine Datenverarbeitungseinrichtung übermitteln.

Ein Temperatursensor 121 wie der in Fig. 6 dargestellte lässt sich beispielsweise gemäß dem in Fig. 7 dargestellten Schema mit einer Datenverarbeitungseinrichtung 123 koppeln. Die Datenverarbeitungseinrichtung ist weiterhin mit einem Schalter 124 gekoppelt und kann über diesen das Heizelement 116 aktivieren. Bei dem Heizelement 116 handelt es sich insbesondere um das in den Figuren 4 und 5 dargestellte.

## Patentansprüche

1. Modular aufgebaute Batterie (100) zur Speicherung elektrischer Energie, umfassend
a. ein Batteriegehäuse (101a, 101b),
b. einen Modulverbund (102) aus mindestens zwei Batteriemodulen (103a bis 103u) mit jeweils mindestens einer positiven und mindestens einer negativen Elektrode, und
c. ein Pressmittel (107),
wobei
d. das Batteriegehäuse (101a, 101b) einen Innenraum umschließt, in dem der Modulverbund (102) angeordnet ist, wobei der Modulverbund (102) den Innenraum nicht vollständig ausfüllt, so dass ein Totvolumen (116) verbleibt,
e. die mindestens zwei Batteriemodule (103a bis 103u) durch elektrische Verschaltung miteinander verbunden sind,
f. die mindestens zwei Batteriemodule (103a bis 103u) in dem Modulverbund (102) nebeneinander angeordnet sind,
g. gegebenenfalls zwischen benachbarten Batteriemodulen in dem Modulverbund (102) jeweils ein Trennelement angeordnet ist und
h. das Pressmittel (107) auf die Batteriemodule (103a bis 103u) in dem Modulverbund (102) einen Pressdruck ausübt, der benachbarte Batteriemodule (103) des Modulverbunds (102) gegeneinander oder gegen das gegebenenfalls zwischen ihnen angeordnete Trennelement presst,
**dadurch gekennzeichnet, dass**
i. die Batterie (100)
- eine Kraftmesseinrichtung, mit der eine Kraft, die dem von dem Pressmittel (107) ausgeübten Pressdruck entgegengerichtet ist, detektieren werden kann, und/oder
- eine Temperaturmesseinrichtung (121), die eine Temperatur in dem Batteriegehäuse (101a, 101b) und/oder eine Temperatur einzelner Batteriemodule (103a bis 103u) des Modulverbunds (102) detektieren kann, und/oder
- eine Spannungsmesseinrichtung, die eine Änderung einer von dem Modulverbund (102) abgegebenen Spannung in Folge eines Defekts mindestens eines der Batteriemodule (103a bis 103u) des Modulverbunds (102) detektieren kann, und/oder
- eine Strommesseinrichtung, die eine Änderung des von dem Modulverband (102) abgegebenen Stroms in Folge eines Defekts mindestens eines der Batteriemodule (103a bis 103u) des Modulverbunds (102) detektieren kann,
umfasst, wobei die Einrichtung oder die Einrichtungen mit einer Datenverarbeitungseinrichtung (123) gekoppelt ist oder sind, an die Messergebnisse der Einrichtung oder der Einrichtungen übermittelt werden,
j. die Batterie in dem Innenraum des Batteriegehäuses (101a, 101b) mindestens ein Sicherungsmittel aufweist, das bei einem Defekt mindestens eines der Batteriemodule (103f) eine Reduzierung des auf die Batteriemodule (103a bis 103u) ausgeübten Pressdrucks herbeiführt,
k. das Sicherungsmittel ein Mittel (116) zur Zerstörung des Pressmittels ist oder umfasst, das das Pressmittel (107) im Fall des Defekts zerstört, und
l. dieses Mittel (116) zur Zerstörung mit der Datenverarbeitungseinrichtung (123) gekoppelt ist und die Zerstörung des Pressmittels (107) auf ein Signal der Datenverarbeitungseinrichtung (123) initiiert,
wobei
m. die Datenverarbeitungseinrichtung dazu ausgebildet ist, einen Messwert von einer der Einrichtungen mit einem gespeicherten Schwellenwert, dessen Überschreitung einen Defekt in mindestens einem der Batteriemodule anzeigt, abzugleichen und ausschließlich im Fall einer Überschreitung dieses Schwellenwerts das Sicherungsmittel auszulösen.

2. Batterie (100) nach Anspruch 1 mit dem folgenden zusätzlichen Merkmal:
a. Die Datenverarbeitungseinrichtung (123) ist Bestandteil der Batterie (100).

3. Batterie nach Anspruch 1 oder Anspruch 2 mit mindestens einem der folgenden zusätzlichen Merkmale:
a. Das Pressmittel (107) ist oder umfasst mindestens ein Spannband, insbesondere mindestens ein elastisch gedehntes Spannband, das den Modulverbund (102) umschließt.
b. Das Pressmittel ist oder umfasst mindestens einen Spannrahmen, der den Modulverbund umschließt.
c. Das Pressmittel umfasst mindestens eine Spannfeder.
d. Das Pressmittel umfasst mindestens einen Zuganker, der am und/oder in dem Modulverbund verlegt ist.
e. Das Spannband ist ein elastisch gedehntes Spannband aus Kunststoff oder aus einem Verbundwerkstoff aus Kunststoff und einem Fasermaterial.

4. Batterie nach einem der Ansprüche 1 bis 3 mit dem folgenden zusätzlichen Merkmal:
a. Die Kraftmesseinrichtung ist Bestandteil des Modulverbunds oder des Pressmittels.

5. Batterie nach einem der vorhergehenden Ansprüche mit mindestens einem der folgenden zusätzlichen Merkmale:
a. Das Batteriegehäuse (101a, 101b) ist flüssigkeitsdicht und gasdicht verschlossen.
b. Das Totvolumen nimmt zwischen 1 % und 10 % des Innenraums ein.

6. Batterie nach einem der vorhergehenden Ansprüche mit mindestens einem der folgenden zusätzlichen Merkmale:
a. Das Sicherungsmittel ist dazu ausgebildet, das Presselement oder ein Bestandteil des Presselements zur Reduzierung des Pressdrucks zu zerstören.
b. Das Sicherungsmittel ist dazu ausgebildet, einen Druck herbeizuführen, der dem Pressdruck, der die Batteriemodule (103a bis 103u) in dem Modulverbund (102) gegeneinander presst, entgegengerichtet ist.

7. Batterie nach einem der Ansprüche 1 bis 6 mit dem folgenden zusätzlichen Merkmal:
a. Das Sicherungsmittel bewirkt bei dem Defekt des mindestens einen der Batteriemodule einen vollständigen Wegfall des Pressdrucks.

8. Verfahren zum gesicherten Betrieb einer Modular aufgebaute Batterie gemäß dem Oberbegriff von Anspruch 1,
**dadurch gekennzeichnet, dass**
die Datenverarbeitungseinrichtung einen Messwert von einer der Einrichtungen mit einem gespeicherten Schwellenwert, dessen Überschreitung einen Defekt in mindestens einem der Batteriemodule anzeigt, abgleicht und ausschließlich im Fall einer Überschreitung dieses Schwellenwerts das Sicherungsmittel auslöst und
das Sicherungsmittel eine Reduzierung des auf die Batteriemodule (103a bis 103u) ausgeübten Pressdrucks herbeiführt.

## Claims

1. Battery (100) of modular construction for storing electrical energy, comprising
a. a battery housing (101a, 101b),
b. a module assembly (102) comprising at least two battery modules (103a to 103u), each with at least one positive and at least one negative electrode, and
c. a pressing means (107),
wherein
d. the battery housing (101a, 101b) surrounds an interior in which the module assembly (102) is arranged, wherein the module assembly (102) does not completely fill the interior, so that a dead volume (116) remains,
e. the at least two battery modules (103a to 103u) are connected to one another by electrical interconnection,
f. the at least two battery modules (103a to 103u) are arranged next to one another in the module assembly (102),
g. a respective disconnection element may be arranged between adjacent battery modules in the module assembly (102), and
h. the pressing means (107) exerts a mechanical pressure onto the battery modules (103a to 103u) in the module assembly (102), the said mechanical pressure pressing adjacent battery modules (103) of the module assembly (102) against one another or against the disconnection element which may be arranged between them, **characterized in that**
i. the battery (100) comprises
- a force-measuring device with which a force which is directed against the mechanical pressure which is exerted by the pressing means (107) can be detected, and/or
- a temperature-measuring device (121) which can detect a temperature in the battery housing (101a, 101b) and/or a temperature of individual battery modules (103a to 103u) of the module assembly (102), and/or
- a voltage-measuring device which can detect a change in a voltage, which is output by the module assembly (102), as a result of a defect in at least one of the battery modules (103a to 103u) of the module assembly (102), and/or
- a current-measuring device which can detect a change in the current, which is output by the module assembly (102), as a result of a defect in at least one of the battery modules (103a to 103u) of the module assembly (102),
wherein the device or the devices is or are coupled to a data-processing device (123) to which measurement results from the device or from the devices are transmitted,
j. the battery has at least one safety means in the interior of the battery housing (101a, 101b), the said safety means triggering a reduction in the mechanical pressure, which is exerted onto the battery modules (103a to 103u), when there is a defect in at least one of the battery modules (103f),
k. the safety means is or comprises a means (116) for destroying the pressing means, the said means destroying the pressing means (107) in the case of a defect, and
l. this destroying means (116) is coupled to the data-processing device (123) and initiates destruction of the pressing means (107) in response to a signal from the data-processing device (123),
wherein
m. the data-processing device is designed to compare a measured value from one of the devices with a stored threshold value, the situation of this stored threshold value being exceeded indicating a defect in at least one of the battery modules, and to trip the safety means exclusively in the event of this threshold value being exceeded.

2. Battery (100) according to Claim 1, comprising the following additional feature:
a. The data-processing device (123) is a constituent part of the battery (100).

3. Battery according to Claim 1 or Claim 2, comprising at least one of the following additional features:
a. The pressing means (107) is or comprises at least one tensioning strap, in particular at least one elastically stretched tensioning strap, which surrounds the module assembly (102).
b. The pressing means is or comprises at least one tensioning frame which surrounds the module assembly.
c. The pressing means comprises at least one tensioning spring.
d. The pressing means comprises at least one tie rod which is laid on and/or in the module assembly.
e. The tensioning strap is an elastically stretched tensioning strap composed of plastic or composed of a composite material comprising plastic and a fibre material.

4. Battery according to one of Claims 1 to 3, comprising the following additional feature:
a. The force-measuring device is a constituent part of the module assembly or of the pressing means.

5. Battery according to one of the preceding claims, comprising at least one of the following additional features:
a. The battery housing (101a, 101b) is closed in a liquid-tight and gas-tight manner.
b. The dead volume occupies between 1% and 10% of the interior.

6. Battery according to one of the preceding claims, comprising at least one of the following additional features:
a. The safety means is designed to destroy the pressing element or a constituent part of the pressing element for the purpose of reducing the mechanical pressure.
b. The safety means is designed to create a pressure which is directed opposite to the mechanical pressure which presses the battery modules (103a to 103u) against one another in the module assembly (102).

7. Battery according to one of Claims 1 to 6, comprising the following additional feature:
a. The safety means brings about complete withdrawal of the mechanical pressure in the event of the defect in the at least one of the battery modules.

8. Method for safe operation of a battery of modular construction according to the preamble of Claim 1, **characterized in that** the data-processing device compares a measured value from one of the devices with a stored threshold value, the situation of this stored threshold value being exceeded indicating a defect in at least one of the battery modules, and trips the safety means exclusively in the event of this threshold value being exceeded, and the safety means triggers a reduction in the mechanical pressure, which is exerted onto the battery modules (103a to 103u).

## Revendications

1. Batterie (100) de construction modulaire destinée au stockage d'énergie électrique, comprenant
a. un boîtier de batterie (101a, 101b),
b. un groupement de modules (102) constitué d'au moins deux modules de batterie (103a à 103u) comprenant respectivement au moins une électrode positive et au moins une électrode négative, et
c. un moyen de pressage (107),
d. le boîtier de batterie (101a, 101b) entourant un espace intérieur dans lequel est disposé le groupement de modules (102), le groupement de modules (102) ne remplissant pas complètement l'espace intérieur, de sorte qu'il reste un volume mort (116),
e. les au moins deux modules de batterie (103a à 103u) étant reliés entre eux par interconnexion électrique,
f. les au moins deux modules de batterie (103a à 103u) étant disposés les uns à côté des autres dans le groupement de modules (102),
g. le cas échéant, un élément de séparation étant respectivement disposé entre des modules de batterie voisins dans le groupement de modules (102) et
h. le moyen de pressage (107) exerçant sur les modules de batterie (103a à 103u) dans le groupement de modules (102) une pression de pressage qui presse les modules de batterie (103) voisins du groupement de modules (102) les uns contre les autres ou contre l'élément de séparation éventuellement disposé entre eux,
**caractérisé en ce que**
i. la batterie (100) comporte
- un dispositif de mesure de force qui permet de détecter une force qui est dirigée à l'opposé de la pression de pressage exercée par le moyen de pressage (107), et/ou
- un dispositif de mesure de température (121) qui peut détecter une température dans le boîtier de batterie (101a, 101b) et/ou une température de modules de batterie individuels (103a à 103u) du groupement de modules (102), et/ou
- un dispositif de mesure de tension qui peut détecter une variation d'une tension délivrée par le groupement de modules (102) suite à un défaut d'au moins l'un des modules de batterie (103a à 103u) du groupement de modules (102), et/ou
- un dispositif de mesure de courant qui peut détecter une variation d'un courant délivré par le groupement de modules (102) suite à un défaut d'au moins l'un des modules de batterie (103a à 103u) du groupement de modules (102),
le dispositif ou les dispositifs étant couplé(s) à un dispositif de traitement de données (123) auquel sont communiqués les résultats de mesure du dispositif ou des dispositifs,
j. la batterie possède, dans l'espace intérieur du boîtier de batterie (101a, 101b), au moins un moyen de sécurité qui, en cas de défaillance d'au moins l'un des modules de batterie (103f), provoque une réduction de la pression de pressage exercée sur les modules de batterie (103a à 103u),
k. le moyen de sécurité est ou comprend un moyen (116) destiné à détruire le moyen de pressage, lequel détruit le moyen de pressage (107) en cas de défaut, et
l. ce moyen (116) de destruction est couplé au dispositif de traitement de données (123) et initie la destruction du moyen de pressage (107) sur un signal du dispositif de traitement de données (123),
m. le dispositif de traitement de données étant configuré pour comparer une valeur de mesure provenant de l'un des dispositifs avec une valeur de seuil mémorisée dont le dépassement indique un défaut dans au moins l'un des modules de batterie et pour déclencher le moyen de sécurité exclusivement en cas de dépassement de cette valeur de seuil.

2. Batterie (100) selon la revendication 1, comprenant la caractéristique supplémentaire suivante :
a. le dispositif de traitement des données (123) fait partie intégrante de la batterie (100).

3. Batterie selon la revendication 1 ou la revendication 2, comprenant au moins l'une des caractéristiques supplémentaires suivantes :
a. le moyen de pressage (107) est ou comprend au moins une bande de serrage, notamment au moins une bande de serrage étirée élastiquement, qui entoure le groupement de modules (102),
b. le moyen de pressage est ou comprend au moins un cadre de serrage qui entoure le groupement de modules,
c. le moyen de pressage comprend au moins un ressort de tension,
d. le moyen de pressage comprend au moins un tirant qui est posé sur et/ou dans le groupement de modules,
e. la bande de serrage est une bande de serrage étirée élastiquement en matière plastique ou en un matériau composite composé de plastique et d'un matériau fibreux.

4. Batterie selon l'une des revendications 1 à 3, comprenant la caractéristique supplémentaire suivante :
a. le dispositif de mesure de force fait partie intégrante du groupement de modules ou du moyen de pressage.

5. Batterie selon l'une des revendications précédentes, comprenant au moins l'une des caractéristiques supplémentaires suivantes :
a. le boîtier de la batterie (101a, 101b) est fermé de manière étanche aux liquides et hermétique aux gaz,
b. le volume mort occupe entre 1 % et 10 % de l'espace intérieur.

6. Batterie selon l'une des revendications précédentes, comprenant au moins l'une des caractéristiques supplémentaires suivantes :
a. le moyen de sécurité est configuré pour détruire l'élément de pressage ou un composant de l'élément de pressage afin de réduire la pression de pressage,
b. le moyen de sécurité est configuré pour créer une pression qui est opposée à la pression de pressage qui presse les modules de batterie (103a à 103u) les uns contre les autres dans le groupement de modules (102).

7. Batterie selon l'une des revendications 1 à 6, comprenant la caractéristique supplémentaire suivante :
a. le moyen de sécurité provoque une disparition totale de la pression de pressage en cas de défaillance d'au moins l'un des modules de batterie.

8. Procédé de fonctionnement sécurisé d'une batterie modulaire selon le préambule de la revendication 1, **caractérisé en ce que** le dispositif de traitement de données compare une valeur de mesure provenant de l'un des dispositifs avec une valeur de seuil mémorisée dont le dépassement indique un défaut dans au moins l'un des modules de batterie et, uniquement en cas de dépassement de cette valeur de seuil, déclenche le moyen de sécurité et le moyen de sécurité provoque une réduction de la pression de pressage exercée sur les modules de batterie (103a à 103u).
